# EUROPEAN PATENT SPECIFICATION

(11) **EP 2 775 806 B1**
(45) Date of publication and mention of the grant of the patent: **04.03.2015**
(21) Application number: 13158147.2
(22) Date of filing: 07.03.2013
(51) Int. Cl.: H05K 1/02, H04B 10/69

(54) **Optical receiver and transceiver using the same**
Optischer Empfänger und Sender-Empfänger damit
Récepteur optique et émetteur-récepteur l'utilisant

(43) Date of publication of application: 10.09.2014
(73) Proprietor: Tyco Electronics Svenska Holdings AB, 175 26 Jaerfaella (SE)
(72) Inventor: Kaikkonen, Andrei, 17548 Jaerfaella (SE); Lundqvist, Lennart Per Olof, 17760 Jaerfaella (SE); Svensson, Lars-Göte, 191 33 Sollentuna (SE); Lindberg, Peter, 75229 Uppsala (SE)
(74) Representative: Grünecker, Kinkeldey, Stockmair & Schwanhäusser

(56) References cited:
- WO-A1-2012/147803
- US-A1- 2004 090 289
- US-A1- 2012 162 932
- US-A1- 2012 170 944

## Description

The present invention relates to an optical receiver for receiving an optical signal, for converting the optical signal into an electric signal and for outputting the electrical signal. Particularly, the optical receiver is an optical data receiver for receiving data at a predetermined data rate. The present invention also relates to a transceiver including the optical receiver/optical data receiver of the present invention and a transmitter for receiving an electric signal, converting the electric signal into an optical signal and outputting the optical signal.

In order to support the communication requirements of high-speed data transmission applications (for instance, at a bit rate of 25 Gpbs) optical links are used when links via an electrical wire have a too low bandwidth. When using an optical link for transmitting a signal from a first electronic component to a second electronic component, the electric signal to be transmitted is first converted into an optical signal, then the optical signal is coupled into an optical fiber via an optical transmitter and transmitted to the second electronic component via the optical fiber. At the second electronic component the optical signal is received via an optical receiver and converted into an electrical signal. Then the converted electrical signal is further processed in the second electronic component.

US 2012/0170944 A1 discloses an optical receiver including a board to be coupled with an optical transmission line array, and an optical diode array disposed on the board. The optical diode array includes a plurality of photo diodes each of which receives light from a corresponding optical transmission line in the optical transmission array. Further bias suppliers, conversion circuits, and capacitors are provided on the board. Each of the photo diodes includes a first electrode and second electrodes, the first electrode receives a bias voltage supplied by a bias supplier, a current signal flowing through the second electrode is converted by a conversion circuit into a voltage signal, and one end of a capacitor is coupled to the first electrode and the other is grounded.

WO 2012/147803 A1 shows a circuit substrate having three wiring layers. A signal line is formed in a first wiring layer, a ground plane is formed in a second wiring layer, and a resonance line is formed in a third wiring layer. A circular slit is formed in the ground plane and an island electrode separated from the ground plane is formed inside the slit. One end of the resonance line is connected to the island electrode by an inter-layer connection via and the other end of the resonance line is connected to the ground plane by an inter-layer connection via. A transmission line is formed by the signal line and the ground plane and a composite resonator is configured so as to contain the transmission line. The signal component in the resonance frequency is band-removed from among the signals propagating the transmission line.

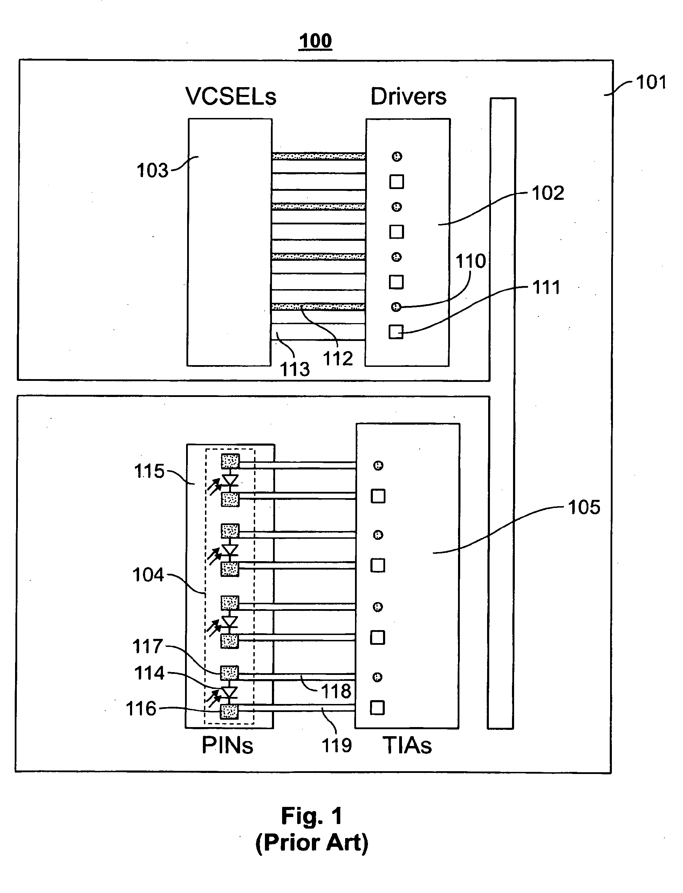

Fig. 1 shows a transceiver 100 of the state-of-the-art that is used for converting an electric signal into an optical signal and vice-versa. The transceiver 100 includes a dielectric non-conductive substrate (not shown in Fig. 1), a ground plane 101 placed on the dielectric non-conductive substrate, an array of four drivers 102, an array of four laser diodes 103 (for instance, vertical cavity surface emitting lasers, abbreviated VCSEL) that are connected to respective outputs of the drivers 102, an array of four photodiodes 104 (for instance, positive intrinsic negative diodes, abbreviated PINs), and an array of four transimpedance amplifiers 105 (abbreviated TIAs) connected to respective outputs of the photodiodes of the array of photodiodes 104. The array of drivers 102, the array of laser diodes 103, the array of photodiodes 104 and the array of TIAs 105 are all placed on the same dielectric non-conductive substrate and surrounded by the ground plane 101. Additionally, the array of photodiodes 104 is placed in the interior of an opening provided in the ground plane 101, so as to isolate the array of photodiodes 104 from the ground plane 101.

Each driver of the driver array 102 receives at its input (not shown in Fig. 1) an electric signal from, for instance, a motherboard of a computer (not shown in Fig. 1), converts the received electrical signal into a single ended electrical signal, and outputs this via output terminals 110 and 111 to inputs of a VCSEL of the VCSEL array 103. The output terminal 111 of a driver of the driver array 102 is connected via a ground line 113 to an input of a respective VCSEL of the VCSEL array 103. The output terminal 110 of a driver of the driver array 102 is connected via a signal line 112 to another input of the respective VCSEL. Each VCSEL of the VCSEL array 103 converts the single ended electrical signal received at its inputs to an optical signal, and outputs this to an optical fiber.

Each photodiode 114 of the array of photodiodes 104 receives an optical signal from, for instance an optical fiber (not shown in Fig. 1), converts the received optical signal into a single ended electrical signal, and outputs this via its anode 117 and its cathode 116 to the inputs of a respective TIA. The anode 117 of a photodiode of the array of photodiodes 104 is connected via a signal line 118 to an input of the respective TIA, and the cathode 116 of a photodiode of the array of photodiodes 104 is connected via a ground line 119 to another input of the respective TIA.

As the signal lines connecting outputs of the driver array 102 with respective inputs of the VCSEL array 103 (in the following denoted as Driver-VCSEL channels) and the signal lines connecting anodes 114 of the photodiode array 104 with respective inputs of the TIA array 105 (in the following denoted as PIN-TIA channels) are of single end type, single-end-type crosstalk occurs among these lines, i.e. a transfer of signal power from one or a plurality of signal lines (aggressor lines) to another signal line (victim line) via the common ground plane 101. At the victim line crosstalk overlays with the signal carried by the victim line, thereby degrading its signal quality. Crosstalk can occur among Driver-VCSEL channels, among PIN-TIA channels, but also among Driver-VCSEL channels and PIN-TIA channels, if the array of photodiodes 104 is isolated from ground by the opening 115 provided in the ground plane 101.

The opening 115 formed in the ground plane 101 and surrounding the photodiode array 104 has a rectangular shape and a size of approximately 1 mm x 0.4 mm. The size of the opening is mainly determined by the dimensions of the photodiode array 104 and cannot be reduced arbitrarily. At high frequencies opening 105 acts as a slot resonator whose fundamental frequency is mainly determined by the geometric dimension of the opening 105. A rectangular opening having a size of 1 mm x 0.4 mm has a resonant frequency of about 38 GHz. This is about 3 x 12.5 GHz, wherein 12.5 GHz is the fundamental frequency of the 25 Gbps data transmission. As the opening 115 acts as a slot resonator whose fundamental frequency is almost a multiple of the fundamental frequency of the 25 Gbps data transmission, the opening 115 attracts signal current output by drivers of the driver array 102. This resonant effect, which occurs at approximately 38 GHz, promotes crosstalk from Driver-VCSEL channels to PIN-TIA channels. Particularly, PIN-TIA channels that are placed near to the driver array 102 are affected by crosstalk coming from Driver-VCSEL channels.

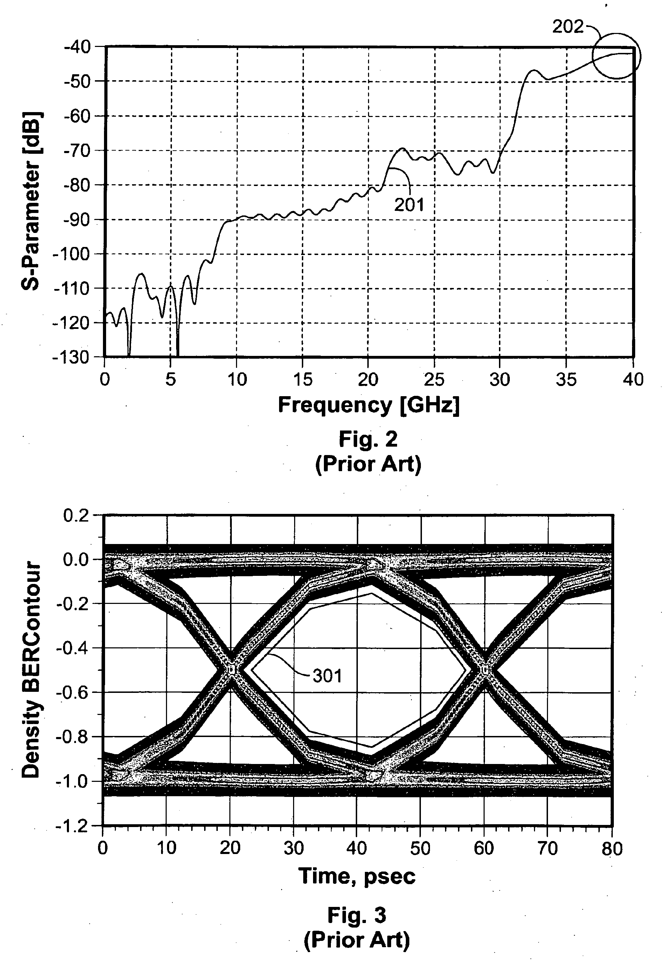

Fig. 2 shows the principle s-parameter coupling coefficient corresponding to the single end type crosstalk from the driver outputs of the driver array 102 to the input of the TIA that is closest to the driver array 102. This is obtained by simulation for the transceiver 100 having all Driver-VCSEL channels (aggressors) activated. The principle s-parameter coupling coefficient 201 exhibits a broad resonance 202 at 38 GHz due to the resonance effect of the opening 115. This resonance 202 induces crosstalk in the TIA input closest to the driver array 102. This crosstalk generates more than 6 ps or 0.15 UI Jitter in the EYE diagram for 25 Gbps, assuming a bit error rate (BER) of 10⁻¹². This becomes evident from Fig. 3, which shows the EYE diagram corresponding to 25 Gbps, for the PIN-TIA channel closest to the driver array 102. The EYE diagram in Fig. 3 has been obtained by simulation under the conditions that the transceiver 100 has all four aggressor channels activated and the ratio between driver output and TIA input current is equal to 100, which corresponds to about -8 dBm optical receiver sensitivity. The outline 301 corresponds to a bit error rate of 10⁻¹².

The resonant behavior of the opening 115 also promotes crosstalk among PIN-TIA channels. This increases with increasing number of photodiodes included in the array of photodiodes 104. When the photodiode array 104 includes 8 or 12 channels, the crosstalk level among PIN-TIA channels can reach an intolerable value.

For a photodiode array including twelve channels, the opening provided in the ground plane and surrounding the photodiode array exhibits a resonance at about 15 GHz. This resonance is close to the fundamental frequency of the 25 Gbps data transmission (which is 12.5 GHz) and thus also promotes crosstalk, thereby degrading signal quality of the PIN-TIA channels.

Crosstalk in the PIN-TIA channels severely degrade the signal quality of the signals input to the TIA array 105, especially of those input to TIAs that are close to the driver array 102.

It is therefore an object of the present invention to reduce crosstalk in the PIN-TIA channels of an optical receiver.

This object is achieved by the features as set forth in claim 1. Further advantageous embodiments of the present invention are set forth in the dependent claims.

The present invention is based on the idea that crosstalk of an electric signal in a PIN-TIA channel of an optical receiver can be effectively reduced by moving the resonant frequency of the opening that isolates the array of photodiodes from the ground plane to a frequency that is sufficiently higher than three times of the fundamental frequency of the crosstalking electric signal.
- **Fig. 1**: shows a schematic of a transceiver of the state of the art;
- **Fig. 2**: shows the principle s-parameter coupling coefficient corresponding to the single end type crosstalk from the driver outputs to the input of the TIA closest to the driver array for the transceiver of the state of the art;
- **Fig. 3**: shows the EYE diagram corresponding to 25 Gbps for the PIN-TIA channel closest to the driver array in the transceiver of the state of the art;
- **Fig. 4**: shows a schematic of an optical receiver according to a first embodiment of the present invention;
- **Fig. 5**: shows a schematic of an optical receiver according to a second embodiment of the present invention;
- **Fig. 6**: shows a schematic of a transceiver including the optical receiver according to the first embodiment of the present invention;
- **Fig. 7**: shows a schematic of a transceiver including the optical receiver according to the second embodiment of the present invention;
- **Fig. 8**: shows a layout of a mask of the optical receiver according to the second embodiment of the present invention;
- **Fig. 9**: shows the principle s-parameter coupling coefficient corresponding to the single end type crosstalk from the driver outputs to the input of the TIA closest to the driver array for the transceiver including the optical receiver according to the second embodiment of the present invention;
- **Fig. 10**: shows the EYE diagram corresponding to 25 Gbps for the PIN-TIA channel closest to the driver array in the transceiver including the optical receiver according to the second embodiment of the present invention;

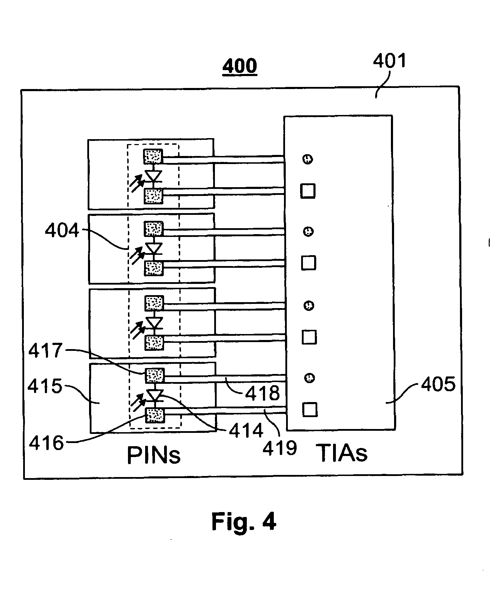

Referring now to Fig. 4, a first advantageous embodiment of an optical receiver according to the present invention, is shown. Fig. 4 shows an optical receiver 400 including a dielectric non-conductive substrate (not shown in Fig. 1), a ground plane 401 placed on the dielectric non-conductive substrate, an array of four photodiodes 404 (e.g. PINs), and an array of four amplifiers 405 (e.g. TIAs) connected to respective outputs of the photodiodes. The array of photodiodes 404 and the array of amplifiers 405 are placed on the dielectric non-conductive substrate and surrounded by the ground plane 401. Four openings 415 are provided in the ground plane 401. Each opening of the four openings 415 surrounds one photodiode 414 so as to isolate the respective photodiode from the ground plane.

Each photodiode 414 of the array of photodiodes 404 receives an optical signal from, for instance, an optical fibre (not shown in Fig. 4), converts the received optical signal into a single ended electrical signal, and outputs this via its anode 417 and cathode 416 to the inputs of a respective amplifier. The anode 417 of a photodiode of the array of photodiodes 404 is connected via signal line 418 to an input of the respective amplifier, and the cathode 416 of a photodiode of the array of photodiodes 404 is connected via a ground line 419 to another input of the respective amplifier.

Each opening 415 of the four openings has a rectangular shape and a size of approximately 0.3 mm x 0.25 mm, so that its resonance frequency is sufficiently higher than 37.5 GHz, preferably 50 GHz or higher. Thus, for this embodiment sufficiently higher is achieved by setting the resonance frequency of the slot resonance to 50 GHz or higher. The minimal length of an opening 415 in the length's direction of the array of photodiodes 404 is determined by the dimensions of a photodiode 414, particularly by the distance between anode and cathode along the optical aperture, and cannot be reduced arbitrarily. As the resonant frequency of each opening 415 of the four openings is sufficiently higher than three times 12.5 GHz, which is the fundamental frequency of the 25 Gbps data transmission, the opening does not act as a slot resonator with the fundamental frequency of 37.5 GHz. Consequently, the opening does not attract signal current via the ground plane if the optical receiver 400 and, for instance, an 25 Gbps data transmitter are placed on the same non-conductive substrate.

As the openings 415 provided in the ground plane 401 of the optical receiver according to the first embodiment of the present invention, do not show a resonant effect at 37.5 GHz, crosstalk of an external signal with a fundamental frequency of 12.5 GHz into the signal line connecting the anode of a photodiode 414 and the input of a respective amplifier (in the following denoted as PIN-TIA channels) is significantly reduced compared to the transceiver of the state of the art 100.

The openings 415 provided in the ground plane 401 also reduce crosstalk between individual PIN-TIA channels of the optical receiver 400 if the fundamental frequency of the signals output by the photodiodes of the array of photodiodes 404 is about 12.5 GHz.

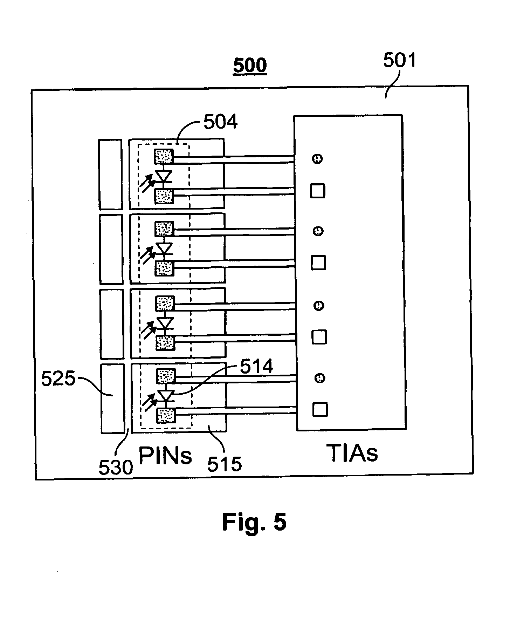

Referring now to Fig. 5, a second advantageous embodiment of an optical receiver according to the present invention, is shown. The optical receiver according to the second embodiment 500 differs from the optical receiver according to the first receiver in that each opening 415 of the optical receiver according to the first embodiment is divided into a first opening 515 and a second opening 525. The first opening 515 and the second opening 525 are separated from each other by a strip line 530 that is connected to the ground plane 501 at both ends. A first opening 515 is an opening that surrounds a photodiode 514 of the array of photodiodes 504, whereas a second opening 525 is an opening that does not surround a photodiode 514 of the array of photodiodes 504. A first opening 515 and its corresponding second opening 525 are placed next to each other. Preferentially, the area of a second opening 525 is smaller than the area of its corresponding first opening 514.

As an opening 415 of the optical receiver according to the first embodiment has a resonance frequency that is sufficiently higher than three times of a predetermined fundamental frequency, the first opening 515 and the second opening 525 of the optical receiver according to the second embodiment have resonant frequencies that are sufficiently higher than three times of the predetermined fundamental frequency. It is essential that each of the first opening 515 and the second opening 525 of the optical receiver according to the second embodiment has a resonant frequency that is sufficiently higher than three times of a predetermined fundamental frequency.

Although the ground plane 501 of the optical receiver according to the second embodiment includes a first opening 515 and a second opening 525 for each photodiode 514 of the array of photodiodes 504, it is conceivable for the present invention that the first opening 515 and the second opening 525 is provided in the ground plane 501 only for a part of the photodiodes of the array of photodiodes 504.

Placing a second opening 525 next to a first opening 515, which surrounds a photodiode 514 of the array of photodiodes 504, reduces crosstalk in the PIN-TIA channels of the optical receiver according to the second embodiment more effectively.

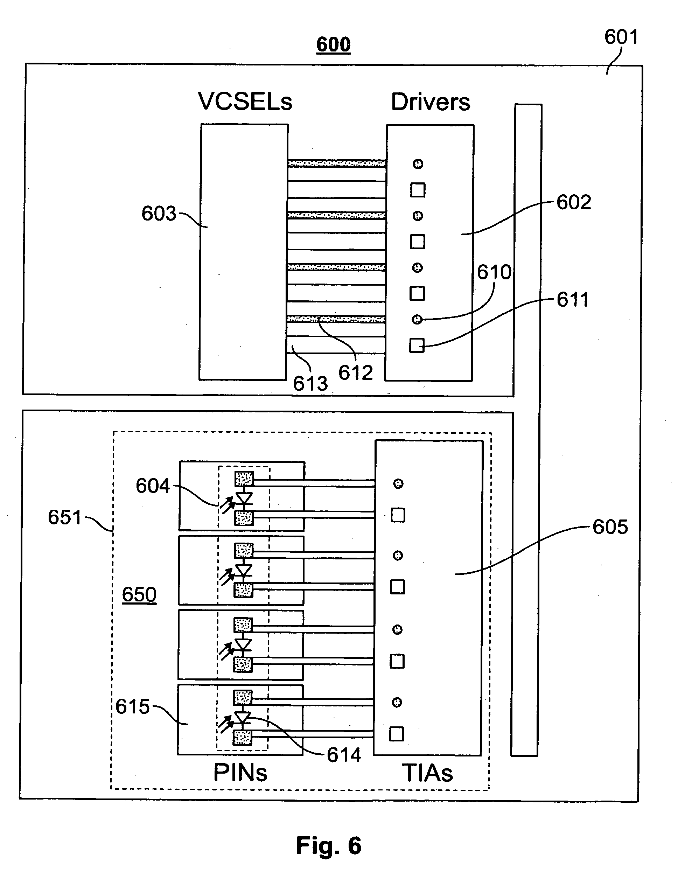

Referring now to Fig. 6, a third advantageous embodiment according to the present invention is shown. Fig. 6 shows a transceiver including the optical receiver according to the first embodiment.

The transceiver 600 includes a dielectric non-conductive substrate (not shown in Fig. 6) a ground plane 601 placed on the dielectric non-conductive substrate, an array of four drivers 602, an array of four laser diodes (VCSEL) 603 that are connected to respective outputs of the drivers of the array of drivers 602, and an optical receiver 650. In Fig. 6, the optical receiver 650 is encircled with the dotted line 651. As the structure of the optical receiver 650 is identical to the optical receiver according to the first embodiment 400, a detailed description of the optical receiver 650 is omitted herein. The array of drivers 602, the array of laser diodes 603, and the optical receivers 650 are placed on the dielectric non-conductive substrate.

Each driver of the driver array 602 receives at its inputs (not shown in Fig. 6) an electric signal from, for instance, a motherboard of a computer (not shown in Fig. 6), converts the received electrical signal into a single ended electrical signal and outputs this via output terminals 610 and 611 to inputs of a laser diode of the array of laser diodes 603. The output terminal 611 of a driver of the driver array 602 is connected via a ground line 613 to an input of a respective laser diode of the array of laser diodes 603. The output terminal 610 of a driver of the driver array 602 is connected via a signal line 612 to another input of the respective laser diode. Each laser diode of the array of laser diodes 603 converts the single ended electrical signal received at its inputs to an optical signal, and outputs this to an optical fibre.

As each opening 615 provided in the ground plane 601 of the transceiver 600 has a resonance frequency that is sufficiently higher than 3 times of the fundamental frequency corresponding to the 25 Gbps data communication, none of the openings 615 exhibits a resonance effect at 38 GHz, and in consequence, do not attract current from the Driver-VCSEL channels of the transceiver 600. Therefore, crosstalk in the PIN-TIA channels of the optical receiver 615 is reduced to a tolerable value.

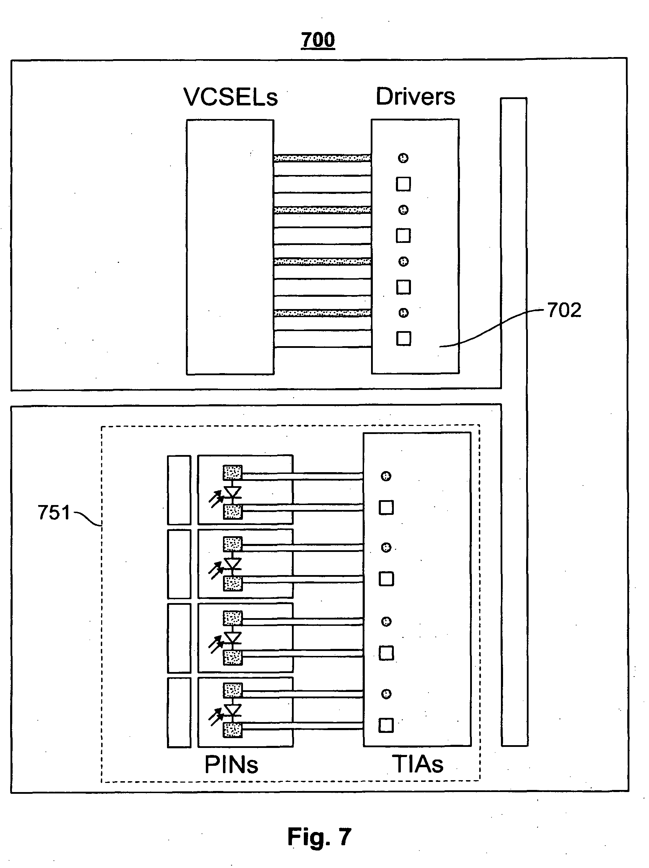

Referring now to Fig. 7, a fourth advantageous embodiment of the present invention is shown. Fig. 7 shows a transceiver 700 differing from the transceiver 600 in that it includes the optical receiver according to the second embodiment instead of the optical receiver according to the first embodiment. The optical receiver of the second embodiment is encircled by the dotted line 751. As the optical receiver of the second embodiment reduces crosstalk in the PIN-TIA channels more efficiently than the optical receiver of the first embodiment, the transceiver 700 reduces crosstalk from the Driver-VCSEL channels into the PIN-TIA channels more efficiently than the transceiver 600.

In the transceivers 600 and 700, the fundamental frequency of the single ended electrical signals output by the drivers of the array of drivers 602, which corresponds to the fundamental frequency of the signal to be transmitted, is identical to the fundamental frequency of the optical signals received at the photodiodes of the optical receiver. In the case of a 25 Gbps data communication, the fundamental frequency of the signals to be transmitted/received is 12.5 GHz. However, the present invention is not limited to 12.5 GHz, but is also applicable to other fundamental frequencies of the signals to be transmitted/received. In this case, however, the dimensions of the openings 415, 515 and 525 have to be changed accordingly.

Also, a transceiver according to the present invention is not limited to the case where the fundamental frequency of the signals to be transmitted is identical to the fundamental frequency of the signals to be received. On the contrary, it is conceivable that the fundamental frequency of the signals to be transmitted is different from the fundamental frequency of the signals to be received.

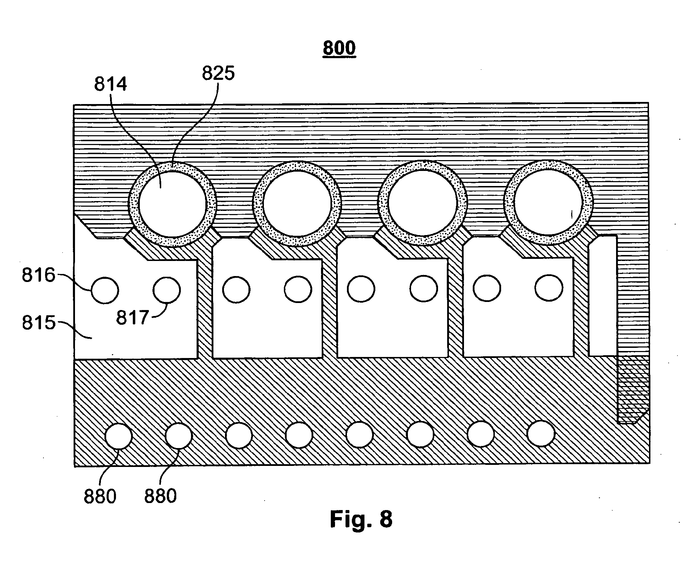

Fig. 8 shows a layout/design 800 of a mask for an optical receiver according to the second embodiment, cf. Fig. 5. Reference numeral 814 denotes a PIN diode corresponding to the photodiode 514 in Fig. 5. Reference numerals 816 and 817 denote the cathode and the anode of the PIN diode 814. Reference numeral 818 denotes the inputs of the TIA connected with the PIN diode 812. The TIAs and the connection lines with the PIN diodes are not shown in Fig. 8. Reference numeral 815 denotes a first opening corresponding to the first opening 515 in Fig. 5. Reference numeral 825 denotes a second opening corresponding to the second opening 525 in Fig. 5. The horizontal and oblique-regions in Fig. 8 represent ground planes corresponding to the ground plane 501 in Fig. 5.

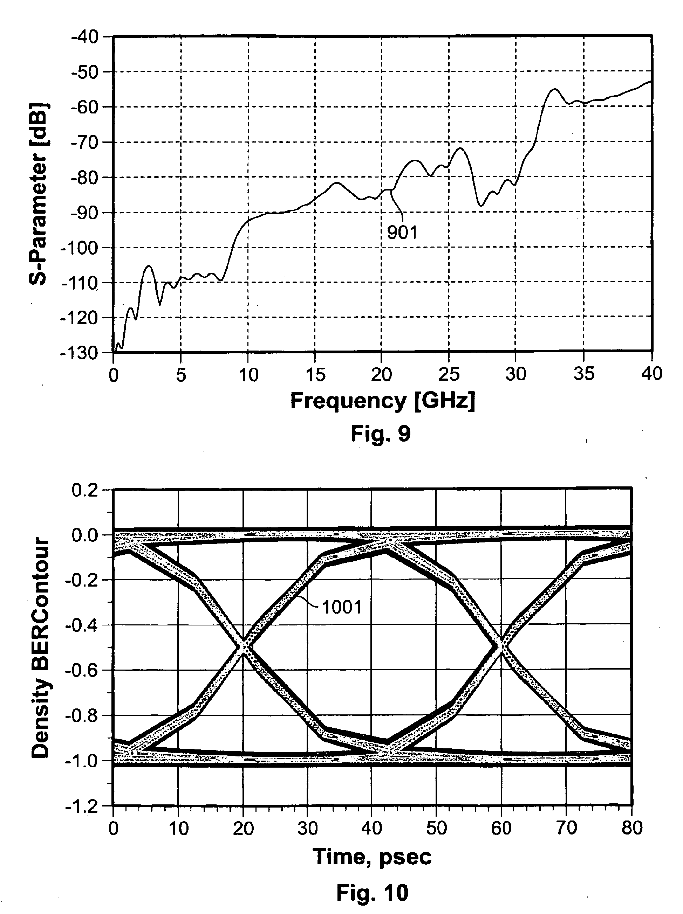

Fig. 10 shows the principle s-parameter coupling coefficient corresponding to the single end type crosstalk from the driver outputs of the driver array 702 to the input of the TIA that is closest to the driver array 702. This is obtained by simulation for the transceiver 700 having all Driver-VCSEL channels activated. The principle s-parameter coupling coefficient 901 does not show a broad resonance at 37.5 GHz. On the contrary, its level at about 37.5 GHz is reduced by 15 dB as compared to Fig. 2. Hence, crosstalk in the TIA input closest to the driver array 102 is significantly reduced. This becomes also evident from Fig. 10, which shows the EYE diagram corresponding to 25 Gbps, for the PIN-TIA channel closest to the driver array 702. The crosstalk in the PIN-TIA channel closest to the driver array 702 generates less than 2 ps or 0.05 UI Jitter in the EYE diagram for 25 Gbps, assuming a bit error rate (BER) of 10⁻¹². The outline 1001 corresponds to a bit error rate of 10⁻¹². The EYE diagram in Fig. 10 has been obtained by simulation under similar conditions as the EYE diagram in Fig. 2, i.e. the transceiver 100 has all four aggressor channels activated and the ratio between driver output and TIA input current is equal to 100, which corresponds to about -8 dBm optical receiver sensitivity.

Although the optical receivers shown in Figs. 4 and 5 have four PIN-TIA channels, the present invention is not limited to optical receivers with four PIN-TIA channels, but is also applicable to optical receivers having an arbitrary number of PIN-TIA channels.

Although the transceivers shown in Figs. 6 and 7 have four Driver-VCSEL channels and four PIN-TIA channels, the present invention is not limited to transceivers with four Driver-VCSEL channels and four PIN-TIA channels, but is also applicable to transceivers having an arbitrary number of Driver-VCSEL channels and an arbitrary number of PIN-TIA channels.

Although the openings provided in the ground planes of the optical receivers according to the first and second embodiments have a rectangular shape, the present invention is not limited to openings having a rectangular shape, but is also applicable to openings having a circular shape, an oval shape, a rhombic shape, or any other shape. It is merely important that the resonance frequency of the openings is sufficiently higher than three times the fundamental frequency of the signal that induces crosstalk in the PIN-TIA channel.

**Reference Numerals**

| Reference Numeral | Description |
|---|---|
| 100, 600, 700 | Transceiver |
| 101, 401, 501, 601 | Ground plane |
| 102, 602, 702 | Driver Array |
| 103, 603 | Array of laser diodes (VCSELs) |
| 104, 404, 504, 604 | Array of photodiodes (PINs) |
| 105, 405, 605 | Array of amplifiers (TIAs) |
| 110, 610 | Driver output (signal) |
| 111, 611 | Driver output (ground) |
| 112, 612 | Single ended signal line |
| 113, 613 | Ground line |
| 114, 414, 514, 614 | Photodiode (PIN) |
| 115, 415, 515, 615 | Opening/First opening in ground plane |
| 116, 416 | Cathode of photodiode (PIN) |
| 117, 417 | Anode of photodiode (PIN) |
| 118, 418 | Single ended signal line |
| 119, 419 | Ground line |
| 201, 901 | S-parameter coupling coefficient |
| 202 | Resonance peak at 38 GHz |
| 301, 1001 | Outline corresponding to BER = 10⁻¹² |
| 400, 500, 650 | Optical receiver |
| 525 | Second opening in ground plane |
| 530 | Strip line delimiting the first opening and the second opening in the ground plane |
| 651, 751 | Doted lines delimiting the optical receiver |
| 814 | Input of photodiode (PIN) |
| 815 | First Opening in ground plane |
| 816 | Cathode of photodiode (PIN) |
| 817 | Anode of photodiode (PIN) |
| 825 | Second opening in ground plane |
| 880 | Amplifier (TIA) inputs |

## Claims

1. An optical receiver for receiving at least one optical signal having a first fundamental frequency, comprising:
a dielectric non-conductive substrate,
a ground plane (401, 501) placed on the dielectric non-conductive substrate,
at least one photodiode (414, 514) placed on the dielectric non-conductive substrate, wherein
the at least one photodiode (414, 514) is adapted to receive the at least one optical signal, to convert the received optical signal in an electrical signal, and to output the electrical signal,
at least one amplifier (405) adapted to receive at an input thereof the electrical signal output by the at least one photodiode (414) and a crosstalking signal having a second fundamental frequency, and
at least one first opening (415, 515) provided in the ground plane (401, 501),
wherein the at least one first opening (415, 515) surrounds the at least one photodiode (414, 514),
**characterized in that**
the at least one first opening (415, 515) does not show a resonance effect at the second fundamental frequency and at a multiple thereof, particularly at a triple thereof.

2. The optical receiver according to claim 1, wherein the at least one first opening (415, 515) has a resonance frequency that is higher than three times of said second fundamental frequency.

3. The optical receiver according to claim 2, wherein said resonance frequency is 50 GHz or more.

4. The optical receiver according to any of claims 1 to 3, wherein the electrical signal received at the input of the at least one amplifier (405) is single ended.

5. The optical receiver according to any of claims 1 to 4, further comprising at least one second opening (525) provided in the ground plane (501), wherein the at least one second opening (525) does not surround a photodiode (514) and is placed next to the at least one first opening (515).

6. The optical receiver according to claim 1 or 2, wherein the optical receiver is adapted to receive a plurality of optical signals, each optical signal of the plurality of optical signals having the first fundamental frequency, the optical receiver comprising:
a plurality of photodiodes (404, 504) placed on the dielectric non-conductive substrate, wherein each photodiode (414, 514) of the plurality of photodiodes is adapted to receive an optical signal of the plurality of optical signals, to convert the received optical signal in a respective electrical signal, and to output the respective electrical signal,
a plurality of amplifiers (405), wherein each amplifier of the plurality of amplifiers is adapted to receive at an input thereof an electrical signal output by a respective photodiode (414, 514) of the plurality of photodiodes and a crosstalking signal having a second fundamental frequency,
a plurality of first openings provided in the ground plane (401, 501),
wherein each opening (415, 515) of the plurality of first openings surrounds at least one photodiode (414, 514) of the plurality of photodiodes (404, 504), and
each opening (415, 515) of the plurality of first openings does not show a resonance effect at the second fundamental frequency and at a multiple thereof, particularly at a triple thereof.

7. The optical receiver according to claim 6, wherein the resonance frequency of each opening (415, 515) of the plurality of first openings is higher than three times of the second fundamental frequency.

8. The optical receiver according to any of claims 1 to 7, wherein the second fundamental frequency is identical to the first fundamental frequency.

9. The optical receiver according to any of claims 6 to 8, wherein the plurality of optical signals includes four optical signals, the plurality of photodiodes (404, 504) includes four photodiodes (414, 514), the plurality of amplifiers (405) includes four amplifiers, the plurality of first openings includes four first openings (415, 515), the second fundamental frequency is 12.5 GHz, and the resonance frequency of each opening (415, 515) of the plurality of first openings is 50 GHz or more.

10. The optical receiver according to claim 9, wherein each opening (415, 515) of the four first openings has a substantially rectangular shape and dimensions of approximately 0.3 mm times 0.25 mm.

11. The optical receiver according to any of claims 6 to 10, wherein the plurality of photodiodes (404, 504) and/or the plurality of amplifiers (405) is linearly arranged in an array.

12. The optical receiver according to any of claims 6 to 11, further comprising a plurality of second openings provided in the ground plane, wherein each opening (525) of the plurality of second openings does not surround a photodiode (514) and is placed next to an opening (515) of the plurality of first openings.

13. The optical receiver according to any of claims 1 to 12, wherein the optical receiver is adapted to receive data at a predetermined bit rate, particularly 25 Gbps, and the second fundamental frequency corresponds to the predetermined bit rate.

14. A transceiver comprising:
an optical receiver (651, 751) according to any of claims 1 to 6,
at least one laser diode (603),
at least one driver (602, 702) adapted to output a single ended electric signal to an input of the at least one laser diode (603),
wherein the fundamental frequency of the single ended electric signal output by the at least one driver (602, 702) corresponds to the second fundamental frequency,
the at least one laser diode (603) is adapted to output an optical signal in accordance with the single ended electric signal received at its input, and
the optical receiver (651, 751), the at least one driver (602, 702) and the at least one laser diode (603) are provided on the dielectric non-conductive substrate and surrounded by the ground plane (601).

15. A transceiver comprising:
an optical receiver (651, 751) according to any of claims 7 to 12,
a plurality of laser diodes (603),
a plurality of drivers (602, 702), each driver of the plurality of drivers is adapted to output a single ended electrical signal to an input of a laser diode of the plurality of laser diodes (603),
wherein the fundamental frequency of the single ended electric signals output by the drivers of the plurality of drivers (602, 702) corresponds to the second fundamental frequency,
each laser diode of the plurality of laser diodes (603) is adapted to output an optical signal in accordance with the single ended electrical signal received at its input, and
the optical receiver (651, 751), the plurality of drivers (602, 702) and the plurality of laser diodes (603) are provided on the dielectric non-conductive substrate and surrounded by the ground plane (601).

## Patentansprüche

1. Optischer Empfänger zum Empfangen mindestens eines optischen Signals mit einer ersten Grundfrequenz, umfassend:
ein dielektrisches nicht leitendes Substrat,
eine auf dem dielektrischen nicht leitenden Substrat angeordnete Masseebene (401,501),
mindestens eine auf dem dielektrischen nicht leitenden Substrat angeordnete Fotodiode (414, 514), worin die mindestens eine Fotodiode (414, 514) dafür eingerichtet ist, das mindestens eine optische Signal zu empfangen, das empfangene optische Signal in ein elektrisches Signal umzusetzen und das elektrische Signal auszugeben,
mindestens einen Verstärker (405), der dafür eingerichtet ist, an einem Eingang desselben das durch die mindestens eine Fotodiode (414) ausgegebene elektrische Signal und ein Übersprechsignal mit einer zweiten Grundfrequenz zu empfangen, und
mindestens eine in der Masseebene (401, 501) vorgesehene erste Öffnung (415, 515),
worin die mindestens eine erste Öffnung (415, 515) die mindestens eine Fotodiode (414, 514) umgibt,
**dadurch gekennzeichnet, dass**
die mindestens eine erste Öffnung (415, 515) bei der zweiten Grundfrequenz und bei einem Vielfachen derselben, insbesondere bei einem Dreifachen derselben, keinen Resonanzeffekt zeigt.

2. Optischer Empfänger nach Anspruch 1, worin die mindestens eine erste Öffnung (415, 515) eine Resonanzfrequenz hat, die höher als das Dreifache der zweiten Grundfrequenz ist.

3. Optischer Empfänger nach Anspruch 2, worin die Resonanzfrequenz 50 GHz oder mehr beträgt.

4. Optischer Empfänger nach einem der Ansprüche 1 bis 3, worin das am Eingang des mindestens einen Verstärkers (405) empfangene elektrische Signal unsymmetrisch ist.

5. Optischer Empfänger nach einem der Ansprüche 1 bis 4, ferner mindestens eine in der Masseebene (501) vorgesehene zweite Öffnung (525) umfassend, worin die mindestens eine zweite Öffnung (525) keine Fotodiode (514) umgibt und in der Nähe der mindestens einen ersten Öffnung (515) angeordnet ist.

6. Optischer Empfänger nach Anspruch 1 oder 2, worin der optische Empfänger dafür eingerichtet ist, eine Vielzahl von optischen Signalen zu empfangen, wobei jedes optische Signal der Vielzahl von optischen Signalen die erste Grundfrequenz hat, wobei der optische Empfänger umfasst:
eine Vielzahl von Fotodioden (404, 504), die auf dem dielektrischen nicht leitenden Substrat angeordnet ist, worin jede Fotodiode (414, 514) der Vielzahl von Fotodioden dafür eingerichtet ist, ein optisches Signal der Vielzahl von optischen Signalen zu empfangen, das empfangene optische Signal in ein jeweiliges elektrisches Signal umzusetzen und das jeweilige elektrische Signal auszugeben,
eine Vielzahl von Verstärkern (405), worin jeder Verstärker der Vielzahl von Verstärkern dafür eingerichtet ist, an einem Eingang desselben ein durch eine jeweilige Fotodiode (414, 514) der Vielzahl von Fotodioden ausgegebenes elektrisches Signal und ein Übersprechsignal mit einer zweiten Grundfrequenz zu empfangen,
eine Vielzahl von in der Masseebene (401, 501) vorgesehenen ersten Öffnungen,
worin jede erste Öffnung (415, 515) der Vielzahl von ersten Öffnungen mindestens eine Fotodiode (414, 514) der Vielzahl von Fotodioden (404, 504) umgibt, und
jede Öffnung (415, 515) der Vielzahl von ersten Öffnungen bei der zweiten Grundfrequenz und bei einem Vielfachen derselben, insbesondere bei einem Dreifachen derselben, keinen Resonanzeffekt zeigt.

7. Optischer Empfänger nach Anspruch 6, worin die Resonanzfrequenz jeder Öffnung (415, 515) der Vielzahl von ersten Öffnungen höher als das Dreifache der zweiten Grundfrequenz ist.

8. Optischer Empfänger nach einem der Ansprüche 1 bis 7, worin die zweite Grundfrequenz mit der ersten Grundfrequenz identisch ist.

9. Optischer Empfänger nach einem der Ansprüche 6 bis 8, worin die Vielzahl von optischen Signalen vier optische Signale aufweist, die Vielzahl von Fotodioden (404, 504) vier Fotodioden (414, 514) aufweist, die Vielzahl von Verstärkern (405) vier Verstärker aufweist, die Vielzahl von ersten Öffnungen vier erste Öffnungen (415, 515) aufweist, die zweite Grundfrequenz 12,5 GHz beträgt und die Resonanzfrequenz jeder Öffnung (415, 515) der Vielzahl von ersten Öffnungen 50 GHz oder mehr beträgt.

10. Optischer Empfänger nach Anspruch 9, worin jede Öffnung (415, 515) der vier ersten Öffnungen eine im Wesentlichen rechteckige Form und Abmessungen von ungefähr 0,3 mm mal 0,25 mm hat.

11. Optischer Empfänger nach einem der Ansprüche 6 bis 10, worin die Vielzahl von Fotodioden (404, 504) und/oder die Vielzahl von Verstärkern (405) in einer linearen Anordnung angeordnet ist.

12. Optischer Empfänger nach einem der Ansprüche 6 bis 11, ferner eine Vielzahl von in der Masseebene vorgesehenen zweiten Öffnungen umfassend, worin jede Öffnung (525) der Vielzahl von zweiten Öffnungen keine Fotodiode (514) umgibt und in der Nähe einer Öffnung (515) der Vielzahl von ersten Öffnungen angeordnet ist.

13. Optischer Empfänger nach einem der Ansprüche 1 bis 12, worin der optische Empfänger dafür eingerichtet ist, Daten mit einer vorbestimmten Bitrate zu empfangen, insbesondere 25 Gbit/s, und die zweite Grundfrequenz der vorbestimmten Bitrate entspricht.

14. Sendeempfänger, umfassend:
einen optischen Empfänger (651, 751) nach einem der Ansprüche 1 bis 6,
mindestens eine Laserdiode (603),
mindestens einen Treiber (602, 702), der dafür eingerichtet ist, ein unsymmetrisches elektrisches Signal an einen Eingang der mindestens einen Laserdiode (603)auszugeben,
worin die Grundfrequenz des durch den mindestens einen Treiber (602, 702) ausgegebenen unsymmetrischen elektrischen Signals der zweiten Grundfrequenz entspricht,
die mindestens eine Laserdiode (603) dafür eingerichtet ist, ein optisches Signal in Entsprechung zu dem an ihrem Eingang empfangenen unsymmetrischen elektrischen Signal auszugeben, und
der optische Empfänger (651, 751), der mindestens eine Treiber (602, 702) und die mindestens eine Laserdiode (603) auf dem dielektrischen nicht leitenden Substrat vorgesehen und von der Masseebene (601) umgeben sind.

15. Sendeempfänger, umfassend:
einen optischen Empfänger (651, 751) nach einem der Ansprüche 7 bis 12,
eine Vielzahl von Laserdioden (603),
eine Vielzahl von Treibern (602, 702), wobei jeder Treiber der Vielzahl von Treibern dafür eingerichtet ist, ein unsymmetrisches elektrisches Signal an einen Eingang einer Laserdiode der Vielzahl von Laserdioden (603) auszugeben,
worin die Grundfrequenz der durch die Treiber der Vielzahl von Treibern (602, 702) ausgegebenen unsymmetrischen elektrischen Signale der zweiten Grundfrequenz entspricht,
jede Laserdiode der Vielzahl von Laserdioden (603) dafür eingerichtet ist, ein optisches Signal in Entsprechung zu dem an ihrem Eingang empfangenen unsymmetrischen elektrischen Signal auszugeben, und
der optische Empfänger (651, 751), die Vielzahl von Treibern (602, 702) und die Vielzahl von Laserdioden (603) auf dem dielektrischen nicht leitenden Substrat vorgesehen und von der Masseebene (601) umgeben sind.

## Revendications

1. Récepteur optique permettant de recevoir au moins un signal optique présentant une première fréquence fondamentale, comprenant :
un substrat non conducteur diélectrique,
un plan de masse (401,501) placé sur le substrat non conducteur diélectrique,
au moins une photodiode (414, 514) placée sur le substrat non conducteur diélectrique, dans lequel la au moins une photodiode (414, 514) est conçue pour recevoir le au moins un signal optique, pour convertir le signal optique reçu en un signal électrique, et pour produire en sortie le signal électrique,
au moins un amplificateur (405) conçu pour recevoir, au niveau d'une entrée de celui-ci, le signal électrique produit en sortie par la au moins une photodiode (414) et un signal de diaphonie présentant une seconde fréquence fondamentale, et
au moins une première ouverture (415, 515) fournie dans le plan de masse (401, 501),
dans lequel la au moins une première ouverture (415, 515) entoure la au moins une photodiode (414, 514),
**caractérisé en ce que**
la au moins une première ouverture (415, 515) ne fait pas apparaître un effet de résonance pour la seconde fréquence fondamentale et pour un multiple de celle-ci, en particulier pour un triple de celle-ci.

2. Récepteur optique selon la revendication 1, dans lequel la au moins une première ouverture (415, 515) présente une fréquence de résonance qui est supérieure à trois fois ladite seconde fréquence fondamentale.

3. Récepteur optique selon la revendication 2, dans lequel ladite fréquence de résonance est de 50 GHz ou davantage.

4. Récepteur optique selon l'une quelconque des revendications 1 à 3, dans lequel le signal électrique reçu au niveau de l'entrée du au moins un amplificateur (405) est asymétrique.

5. Récepteur optique selon l'une quelconque des revendications 1 à 4, comprenant en outre au moins une seconde ouverture (525) fournie dans le plan de masse (501), dans lequel la au moins une seconde ouverture (525) n'entoure pas une photodiode (514) et est placée à proximité de la au moins une première ouverture (515).

6. Récepteur optique selon la revendication 1 ou 2, dans lequel le récepteur optique est conçu pour recevoir une pluralité de signaux optiques, chaque signal optique de la pluralité de signaux optiques présentant la première fréquence fondamentale, le récepteur optique comprenant :
une pluralité de photodiodes (404, 504) placées sur le substrat non conducteur diélectrique, dans lequel chaque photodiode (414, 514) parmi la pluralité de photodiodes est conçue pour recevoir un signal optique parmi la pluralité de signaux optiques, pour convertir le signal optique reçu en un signal électrique respectif, et pour produire en sortie le signal électrique respectif,
une pluralité d'amplificateurs (405), dans lequel chaque amplificateur parmi la pluralité d'amplificateur est conçu pour recevoir, au niveau d'une entrée de celui-ci, un signal électrique produit en sortie par une photodiode (414, 514) respective parmi la pluralité de photodiodes et un signal de diaphonie présentant une seconde fréquence fondamentale,
une pluralité de premières ouvertures fournies dans le plan de masse (401, 501),
dans lequel chaque ouverture (415, 515) parmi la pluralité de premières ouvertures entoure au moins une photodiode (414, 514) parmi la pluralité de photodiodes (404, 504), et
chaque ouverture (415, 515) parmi la pluralité de premières ouvertures ne fait pas apparaître un effet de résonance pour la seconde fréquence fondamentale et pour un multiple de celle-ci, en particulier pour un triple de celle-ci.

7. Récepteur optique selon la revendication 6, dans lequel la fréquence de résonance de chaque ouverture (415, 515) parmi la pluralité de premières ouvertures est supérieure à trois fois la seconde fréquence fondamentale.

8. Récepteur optique selon l'une quelconque des revendications 1 à 7, dans lequel la seconde fréquence fondamentale est identique à la première fréquence fondamentale.

9. Récepteur optique selon l'une quelconque des revendications 6 à 8, dans lequel la pluralité de signaux optiques comprend quatre signaux optiques, la pluralité de photodiodes (404, 504) comprend quatre photodiodes (414, 514), la pluralité d'amplificateurs (405) comprend quatre amplificateurs, la pluralité de premières ouvertures comprend quatre premières ouvertures (415, 515), la seconde fréquence fondamentale est de 12,5 GHz, et la fréquence de résonance de chaque ouverture (415, 515) parmi la pluralité de premières ouvertures est de 50 GHz ou davantage.

10. Récepteur optique selon la revendication 9, dans lequel chaque ouverture (415, 515) parmi les quatre premières ouvertures présente une forme essentiellement rectangulaire et des dimensions d'approximativement 0,3 mm par 0,25 mm.

11. Récepteur optique selon l'une quelconque des revendications 6 à 10, dans lequel la pluralité de photodiodes (404, 504) et/ou la pluralité d'amplificateurs (405) sont agencés de manière linéaire en un réseau.

12. Récepteur optique selon l'une quelconque des revendications 6 à 11, comprenant en outre une pluralité de secondes ouvertures fournies dans le plan de masse, dans lequel chaque ouverture (525) parmi la pluralité de secondes ouvertures n'entoure pas une photodiode (514) et est placée à proximité d'une ouverture (515) parmi la pluralité de premières ouvertures.

13. Récepteur optique selon l'une quelconque des revendications 1 à 12, dans lequel le récepteur optique est conçu pour recevoir des données à un débit binaire prédéterminé, en particulier 25 Gbps, et la seconde fréquence fondamentale correspond au débit binaire prédéterminé.

14. Émetteur-récepteur comprenant :
un récepteur optique (651, 751) selon l'une quelconque des revendications 1 à 6,
au moins une diode laser (603),
au moins un circuit de pilotage (602, 702) conçu pour produire en sortie un signal électrique asymétrique vers une entrée de la au moins une diode laser (603),
dans lequel la fréquence fondamentale du signal électrique asymétrique produit par le au moins un circuit de pilotage (602, 702) correspond à la seconde fréquence fondamentale,
la au moins une diode laser (603) est conçue pour produire en sortie un signal optique en fonction du signal électrique asymétrique reçu au niveau de son entrée, et
le récepteur optique (651, 751), le au moins un circuit de pilotage (602, 702) et la au moins une diode laser (603) sont fournis sur le substrat non conducteur diélectrique et sont entourés par le plan de masse (601).

15. Émetteur-récepteur comprenant :
un récepteur optique (651, 751) selon l'une quelconque des revendications 7 à 12,
une pluralité de diodes laser (603),
une pluralité de circuits de pilotage (602, 702), chaque circuit de pilotage parmi la pluralité de circuits de pilotage étant conçu pour produire en sortie un signal électrique asymétrique vers une entrée d'une diode laser parmi la pluralité de diodes laser (603),
dans lequel la fréquence fondamentale des signaux électriques asymétriques produits en sortie par les circuits de pilotage parmi la pluralité de circuits de pilotage (602, 702) correspond à la seconde fréquence fondamentale,
chaque diode laser parmi la pluralité de diodes laser (603) est conçue pour produire en sortie un signal optique en fonction du signal électrique asymétrique reçu au niveau de son entrée, et
le récepteur optique (651, 751), la pluralité de circuits de pilotage (602, 702) et la pluralité de diodes laser (603) sont fournis sur le substrat non conducteur diélectrique et sont entourés par le plan de masse (601).
